# EUROPEAN PATENT SPECIFICATION

(11) **EP 4 601 451 B1**
(45) Date of publication and mention of the grant of the patent: **20.05.2026**
(21) Application number: 24223643.8
(22) Date of filing: 30.12.2024
(51) Int. Cl.: H10N 69/00, H10W 72/20

(54) **METHOD FOR MANUFACTURING QUANTUM DEVICE**
VERFAHREN ZUR HERSTELLUNG EINER QUANTENVORRICHTUNG
PROCÉDÉ DE FABRICATION DE DISPOSITIF QUANTIQUE

(30) Priority: 07.02.2024 JP 2024017206
(43) Date of publication of application: 13.08.2025
(73) Proprietor: Fujitsu Limited, Kawasaki-shi, Kanagawa 211-8588 (JP)
(72) Inventor: FUKUMORI, Taiga, Kawasaki-shi, Kanagawa 211-8588 (JP)
(74) Representative: Hoffmann Eitle

(56) References cited:
- WO-A1-2020/254040
- JP-A- H1 140 610
- US-A1- 2020 259 064
- US-A1- 2023 309 419
- US-B1- 10 756 004
- CHENG HSIEN-CHIE ET AL: "Theoretical and Experimental Investigation of Warpage Evolution of Flip Chip Package on Packaging during Fabrication", MATERIALS, vol. 14, no. 17, 25 August 2021 (2021-08-25), pages 4816, XP093277917, ISSN: 1996-1944, DOI: 10.3390/ma14174816

## Description

### FIELD

The embodiments discussed herein are related to a method for manufacturing a quantum device.

### BACKGROUND

There is known a configuration in which a substrate, on which a semiconductor device or a qubit device is formed, is mounted over another substrate using a solder bump. In addition, there is known a quantum device in which a qubit chip is mounted over a first substrate, such as an interposer, using a first bump, and the first substrate is mounted over a second substrate, such as a printed circuit board, using a second bump.

Japanese Laid-open Patent Publication No. 2006-310622, U.S. Patent Application Publication No. 2009/0173936, Japanese National Publication of International Patent Application No. 2022-519443, U.S. Patent Application Publication No. 2018/0013052, US2023/0309419 A1, US10756004 B1, WO2020/254040 Al, JP H1140610 A and Japanese Laid-open Patent Publication No. 2023-69792 are disclosed as related art.

### SUMMARY

### TECHNICAL PROBLEM

In the configuration in which the qubit chip is mounted over the first substrate and the first substrate is mounted over the second substrate, it is preferable that the qubit chip is mounted over the first substrate using the first bump, and then the first substrate is mounted over the second substrate using the second bump. This is because, when the first substrate is mounted over the second substrate first, warpage occurs in the first substrate and in the second substrate due to a difference in linear expansion coefficient between the first substrate and the second substrate, and it becomes difficult to mount the qubit chip over the first substrate with high positional accuracy.

The process of mounting the first substrate over the second substrate using the second bump is performed by heating the second bump. For example, the first substrate onto which the qubit chip is mounted and the second substrate are introduced into a heating furnace to heat the second bump, thereby mounting the first substrate over the second substrate. However, when the second bump is heated using the heating furnace, the qubit chip mounted over the first substrate is also heated by the heating furnace so that the temperature thereof increases. When the temperature increases, characteristics of the qubit chip change.

In one aspect, an object is to suppress a change in characteristics of a qubit chip.

### SOLUTION TO PROBLEM

According to an aspect of the embodiments, there is provided a method for manufacturing a quantum device. The present invention is defined by the appended independent method claim 1.

### ADVANTAGEOUS EFFECTS OF INVENTION

In one aspect, a change in characteristics of a qubit chip may be suppressed.

### BRIEF DESCRIPTION OF DRAWINGS

FIG. 1A is a plan view of a quantum device according to a first embodiment, and FIG. 1B is a cross-sectional view taken along line A-A of FIG. 1A;
FIG. 2A is a plan view of a qubit device provided in a qubit chip, FIG. 2B is a plan view of a Josephson junction device, and FIG. 2C is a cross-sectional view taken along line A-A of FIG. 2B;
FIGs. 3A to 3C are cross-sectional views illustrating a method for manufacturing the quantum device according to the first embodiment;
FIG. 4A is a plan view of a quantum device according to a second embodiment, and FIG. 4B is a cross-sectional view taken along line A-A of FIG. 4A;
FIGs. 5A to 5D are diagrams (part 1) illustrating a method for manufacturing the quantum device according to the second embodiment;
FIGs. 6A to 6D are diagrams (part 2) illustrating the method for manufacturing the quantum device according to the second embodiment;
FIG. 7 is a cross-sectional view illustrating another exemplary arrangement of a heat dissipation fin and a thermally conductive member;
FIG. 8A is a plan view of a quantum device according to a third embodiment, and FIG. 8B is a cross-sectional view taken along line A-A of FIG. 8A;
FIGs. 9A to 9D are diagrams (part 1) illustrating a method for manufacturing the quantum device according to the third embodiment;
FIGs. 10A to 10D are diagrams (part 2) illustrating the method for manufacturing the quantum device according to the third embodiment;
FIGs. 11A and 11B are cross-sectional views illustrating an outer shape and an amount of warpage of an interposer;
FIG. 12A is a plan view illustrating a method for manufacturing a quantum device according to a fourth embodiment, and FIG. 12B is a cross-sectional view taken along line A-A of FIG. 12A;
FIG. 13A is a plan view of a quantum device according to a fifth embodiment, and FIG. 13B is a plan view of a quantum device according to a variation of the fifth embodiment;
FIG. 14 is a cross-sectional view of a quantum device according to a sixth embodiment; and
FIGs. 15A to 15D are cross-sectional views illustrating a method for manufacturing the quantum device according to the sixth embodiment.

### DESCRIPTION OF EMBODIMENTS

Hereinafter, embodiments will be described with reference to the drawings.

### [First Embodiment]

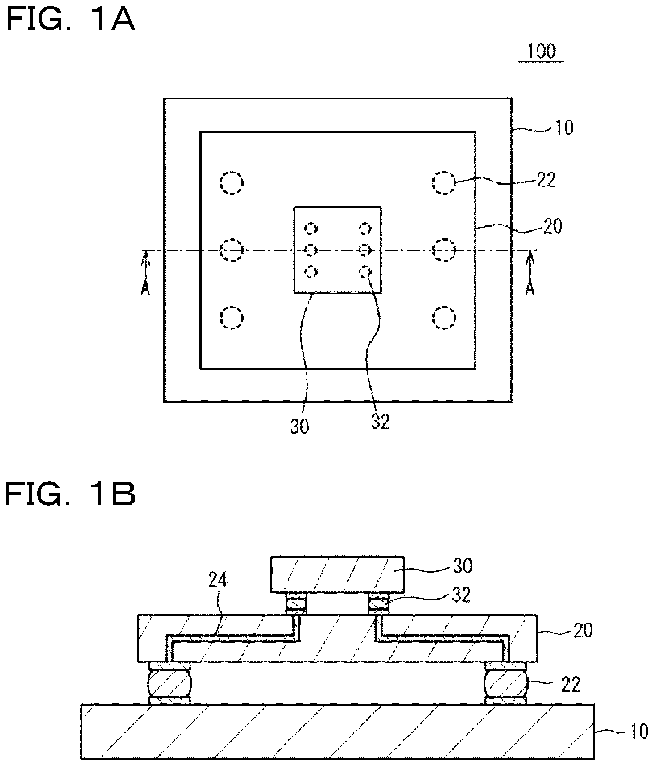

FIG. 1A is a plan view of a quantum device 100 according to a first embodiment, and FIG. 1B is a cross-sectional view taken along line A-A of FIG. 1A. As in FIGs. 1A and 1B, the quantum device 100 according to the first embodiment includes a printed circuit board 10, an interposer 20, and a qubit chip 30. The qubit chip 30 is mounted over the interposer 20 by a first bump 32, which is a joining member. The interposer 20 is mounted over the printed circuit board 10 by a second bump 22, which is a joining member. The first bump 32 and the second bump 22 are electrically coupled by wiring 24 provided in the interposer 20.

The second bump 22 for mounting the interposer 20 over the printed circuit board 10 is, for example, a solder bump, which is formed of Sn-Ag-Cu solder or Sn-Cu solder, for example. The first bump 32 for mounting the qubit chip 30 over the interposer 20 is a bump capable of joining based on lower heat treatment as compared with the second bump 22, and is, for example, an indium (In) bump, a gold (Au) bump, or a copper (Cu) bump. The first bump 32 is smaller in height, width, and pitch than the second bump 22. The second bump 22 is provided at a position not overlapping the qubit chip 30 in plan view. Note that no joining member for joining the printed circuit board 10 and the interposer 20 is provided at a position overlapping the qubit chip 30 in plan view.

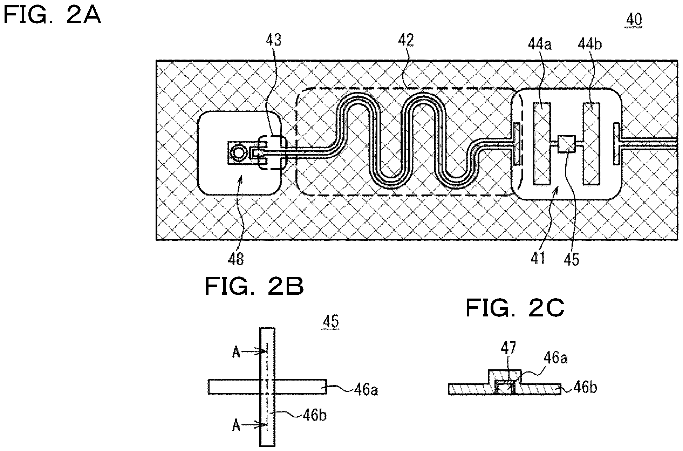

The qubit chip 30 includes a qubit device using Josephson junction. FIG. 2A is a plan view of a qubit device 40 provided in the qubit chip 30, FIG. 2B is a plan view of a Josephson junction device 45, and FIG. 2C is a cross-sectional view taken along line A-A of FIG. 2B. As in FIGs. 2A to 2C, the qubit device 40 includes a qubit 41, a resonator 42, and a filter 43. The qubit 41 includes the Josephson junction device 45 coupled between an electrode 44a and an electrode 44b. In the Josephson junction device 45, a superconducting film 46a and a superconducting film 46b overlap each other via an insulating film 47. The superconducting films 46a and 46b are, for example, aluminum (Al) films. The insulating film 47 is, for example, an aluminum oxide (Al₂O₃) film. In the Josephson junction device 45, one of the superconducting film 46a and the superconducting film 46b is coupled to the electrode 44a, and the other one is coupled to the electrode 44b, thereby being coupled between the electrode 44a and the electrode 44b. The qubit 41 includes a transmon including the Josephson junction device 45 and a capacitor provided with the electrode 44a and the electrode 44b and coupled in parallel to the Josephson junction device 45. The resonator 42 includes, for example, a coplanar line of a meander structure, and one end is electrostatically coupled to the qubit 41. Another end of the resonator 42 is coupled to a reading unit 48 via the filter 43.

### [Manufacturing Method]

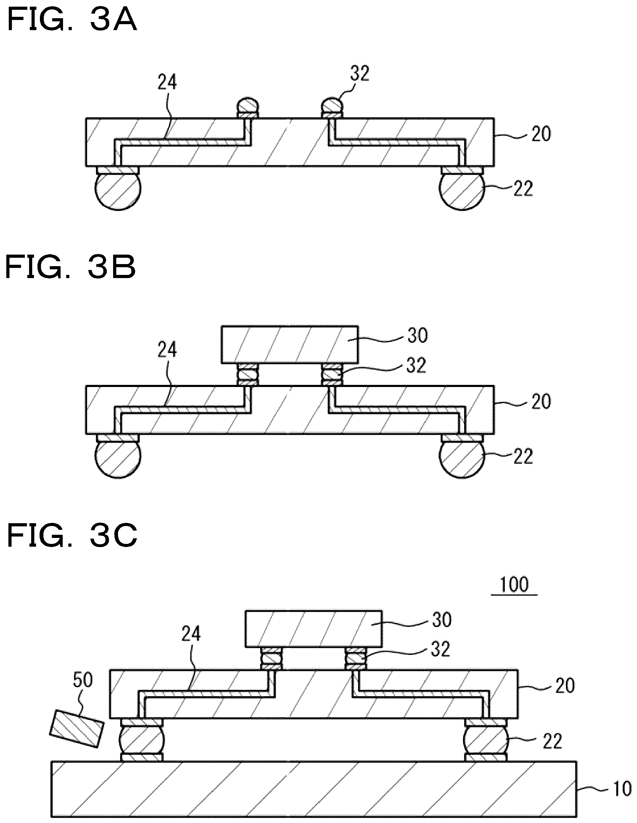

FIGs. 3A to 3C are cross-sectional views illustrating a method according to the present invention for manufacturing the quantum device 100 according to the first embodiment. As in FIG. 3A, the first bump 32 is formed over the upper surface of the interposer 20, and the second bump 22 is formed under the lower surface. The second bump 22 is, for example, a solder bump. The first bump 32 is a bump capable of joining based on lower heat treatment as compared with the second bump 22, and is, for example, an In bump, a Au bump, or a Cu bump.

As in FIG. 3B, the qubit chip 30 is mounted over the interposer 20 by the first bump 32. When the In bump is used for the first bump 32, joining may be carried out based on low-heat treatment at a joining temperature of approximately 140°C and a heating time of approximately 300 seconds. When ultrasonic Au bonding using the Au bump is used, joining may be carried out based on low-heat treatment at a joining temperature of approximately 180°C and a heating time of approximately 3 seconds. When surface activated bonding using the Cu bump is used, joining may be carried out at room temperature. When the temperature of the qubit chip 30 increases, characteristics of the qubit device 40 included in the qubit chip 30 change. For example, when the temperature of the qubit chip 30 increases, the thickness of the insulating film 47 of the Josephson junction device 45 changes, whereby the characteristics of the qubit device 40 change. In view of the above, the joining using the first bump 32 is carried out by low-heat treatment. As a result, an increase in the temperature of the qubit chip 30 is suppressed, whereby a change in the characteristics of the qubit device 40 is suppressed.

The second bump 22 under the lower surface of the interposer 20 is formed to be positioned outside the qubit chip 30 in plan view. That is, the second bump 22 is positioned in a region not overlapping the qubit chip 30 in plan view, and no joining member is provided in a region overlapping the qubit chip 30.

As in FIG. 3C, the interposer 20 is mounted over the printed circuit board 10 using the second bump 22. The second bump 22 is, for example, a solder bump. For example, when the printed circuit board 10, the interposer 20, and the qubit chip 30 are introduced into a heating furnace to heat the second bump 22, the heat treatment is carried out at a temperature of approximately 200°C for a time of approximately 10 minutes. In this case, the temperature of the qubit chip 30 increases, whereby the characteristics of the qubit device 40 change. In view of the above, the second bumps 22 are sequentially and locally heated using a heater 50, such as a heat gun, a soldering iron, or the like, thereby mounting the interposer 20 over the printed circuit board 10. For example, a heat gun of 300 W is used to carry out local heat treatment at a joining temperature of approximately 200°C and a heating time of approximately 10 seconds. As described above, the second bump 22 is locally heated using the heater 50, whereby an increase in the temperature of the qubit chip 30 may be suppressed.

According to the first embodiment, as in FIG. 3B, the qubit chip 30 is mounted over the interposer 20 (first substrate) using the first bump 32. As in FIG. 3C, the second bump 22 provided at a position not overlapping the qubit chip 30 in plan view is locally heated, whereby the interposer 20 is mounted over the printed circuit board 10 (second substrate). In this manner, the second bump 22 provided at a position not overlapping the qubit chip 30 in plan view is locally heated, whereby an increase in the temperature of the qubit chip 30 may be suppressed. Accordingly, a change in the characteristics of the qubit chip 30 may be suppressed.

Furthermore, in the first embodiment, the first bump 32 for mounting the qubit chip 30 over the interposer 20 is an In bump, a Au bump, or a Cu bump. Therefore, the qubit chip 30 may be mounted over the interposer 20 by low-heat treatment, whereby a change in the characteristics of the qubit chip 30 may be suppressed. The second bump 22 for mounting the interposer 20 over the printed circuit board 10 is a solder bump. By such a second bump 22 being locally heated to mount the interposer 20 over the printed circuit board 10, the interposer 20 may be firmly joined to the printed circuit board 10.

Furthermore, in the first embodiment, the second bump 22 is locally heated using a heat gun or a soldering iron as the heater 50. Therefore, the temperature of only the second bump 22 and the surroundings thereof may be increased, and an increase in the temperature of a region away from the second bump 22 may be suppressed, whereby a change in the characteristics of the qubit chip 30 may be suppressed.

Furthermore, in the first embodiment, the qubit chip 30 includes the Josephson junction device 45. The characteristics of the Josephson junction device 45 are likely to change as the temperature increases. In view of the above, when the Josephson junction device 45 is included in the qubit chip 30, it is preferable to apply the manufacturing method illustrated in FIGs. 3A to 3C.

### [Second Embodiment]

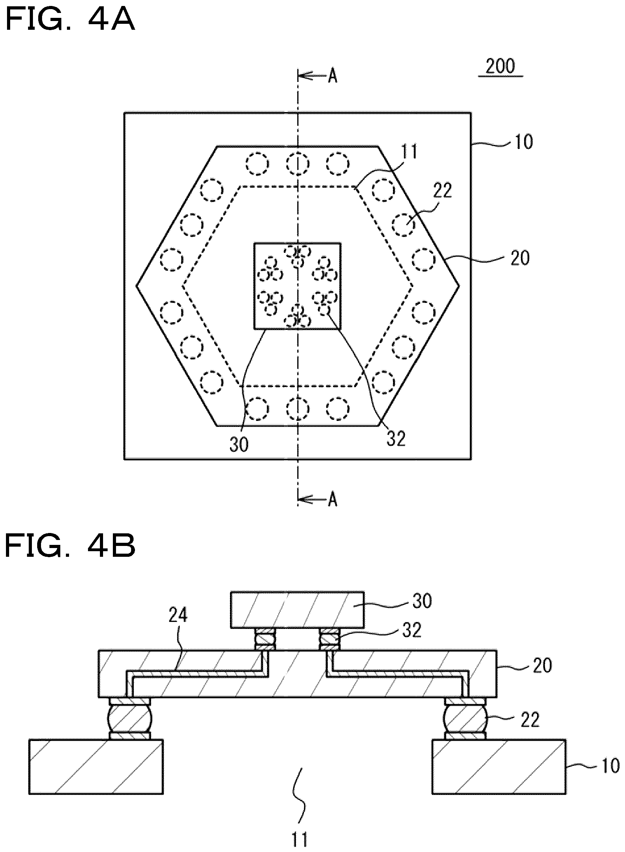

FIG. 4A is a plan view of a quantum device 200 according to a second embodiment, and FIG. 4B is a cross-sectional view taken along line A-A of FIG. 4A. As in FIGs. 4A and 4B, in the quantum device 200 according to the second embodiment, an interposer 20 has a polygonal shape (e.g., hexagonal shape) of a pentagon or a larger polygon in plan view. A printed circuit board 10 has a through hole 11 penetrating from the upper surface to the lower surface. The through hole 11 has, for example, the same polygonal shape (e.g., hexagonal shape) as the interposer 20 in plan view. The interposer 20 is mounted over the printed circuit board 10 by a second bump 22 to cover the through hole 11. A qubit chip 30 is mounted over the interposer 20 to entirely overlap the through hole 11 in plan view. Other configurations are the same as those in the first embodiment, and descriptions thereof will be omitted.

### [Manufacturing Method]

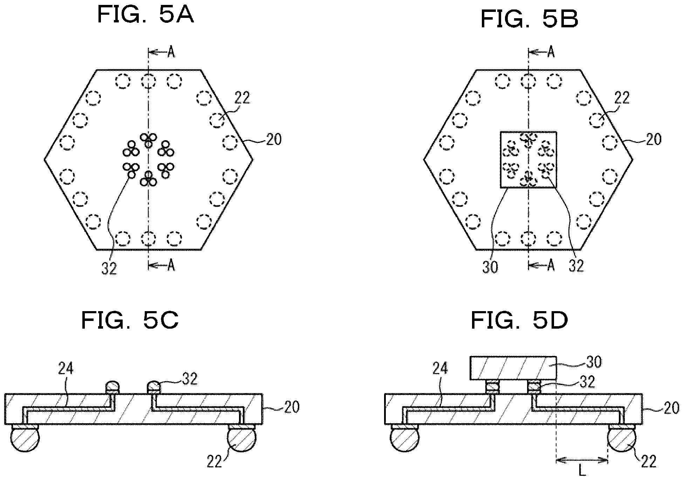

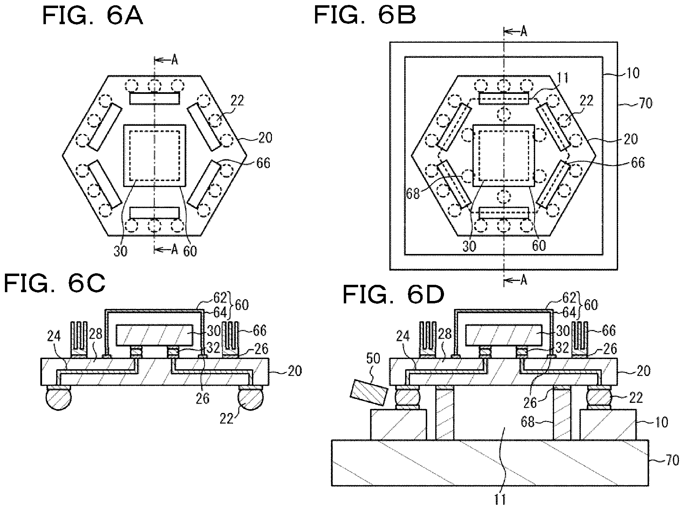

FIGs. 5A to 6D are diagrams illustrating a method according to the present invention for manufacturing the quantum device 200 according to the second embodiment. FIGs. 5A, 5B, 6A, and 6B are plan views illustrating the method for manufacturing the quantum device 200 according to the second embodiment. FIGs. 5C, 5D, 6C, and 6D are cross-sectional views taken along line A-A of FIGs. 5A, 5B, 6A, and 6B.

As in FIG. 5A and 5C, a first bump 32 is formed over the upper surface of the interposer 20 having a polygonal shape (e.g., hexagonal shape) of a pentagon or a larger polygon in plan view, and the second bump 22 is formed under the lower surface. The first bump 32 is formed in a central region of the upper surface of the interposer 20. The second bump 22 is formed in a peripheral region of the lower surface of the interposer 20.

As in FIGs. 5B and 5D, the qubit chip 30 is mounted over the interposer 20 by the first bump 32. The qubit chip 30 is mounted over the interposer 20 by the low-heat treatment described in the first embodiment. In a similar manner to the first embodiment, the second bump 22 is positioned in a region not overlapping the qubit chip 30 in plan view, and no joining member is provided in a region overlapping the qubit chip 30. A distance L between the qubit chip 30 and the second bump 22 is, for example, 2 cm or more and 15 cm or less, and may be 4 cm or more and 12 cm or less, or may be 6 cm or more and 10 cm or less.

As in FIGs. 6A and 6C, a cover portion 60 that covers the qubit chip 30 is disposed over the upper surface of the interposer 20. The cover portion 60 has a box shape having a bottom portion 62 and a wall portion 64. The qubit chip 30 is disposed inside the cover portion 60 having the box shape. The cover portion 60 is merely placed in contact with the upper surface of the interposer 20, for example, and is not joined to the interposer 20. The cover portion 60 may be placed over a metal film 26 of the interposer 20, or may be placed over an insulating film 28. The cover portion 60 may be formed of a metal material, or may be formed of an insulating material such as heat-resistant plastic.

Furthermore, a heat dissipation fin 66 is disposed above the upper surface of the interposer 20. The heat dissipation fin 66 may be formed of, for example, a metal material such as copper, aluminum, or the like. In a similar manner to the cover portion 60, the heat dissipation fin 66 is merely placed in contact with the upper surface of the interposer 20, for example, and is not joined to the interposer 20. The heat dissipation fin 66 may be placed above the metal film 26 of the interposer 20, or may be placed above the insulating film 28.

As in FIGs. 6B and 6D, the printed circuit board 10 is disposed over a heat dissipation stage 70 that also serves as a support base. The printed circuit board 10 is provided with the through hole 11. A thermally conductive member 68 having a columnar shape is disposed at a position inside the through hole 11 and above the heat dissipation stage 70. The thermally conductive member 68 may be formed of, for example, a metal material such as copper, aluminum, or the like. The heat dissipation stage 70 may be a block of metal as long as at least the upper surface thereof is formed of metal such as copper, aluminum, or the like, or may be an insulating block having an upper surface provided with a metal film. The upper surface of the thermally conductive member 68 protrudes from the upper surface of the printed circuit board 10.

Thereafter, the interposer 20 is disposed above the thermally conductive member 68. As a result, the thermally conductive member 68 is positioned between the lower surface of the interposer 20 and the heat dissipation stage 70. The thermally conductive member 68 is in contact with, but not joined to, the lower surface of the interposer 20 and the upper surface of the heat dissipation stage 70, for example. The thermally conductive member 68 may be in contact with the metal film 26 of the interposer 20, or may be in contact with the insulating film 28.

By the second bumps 22 being sequentially and locally heated using the heater 50, the interposer 20 is mounted over the printed circuit board 10. While the heat from the heater 50 is transferred through the air, since the cover portion 60 is provided to cover the qubit chip 30, an increase in the temperature of the qubit chip 30 due to the heat transferred through the air may be suppressed. Furthermore, the heat from the heater 50 is also transferred to the interposer 20. However, since the interposer 20 is provided with the heat dissipation fin 66 and the thermally conductive member 68, the heat transmitted through the interposer 20 is dissipated into the air by the heat dissipation fin 66, and is dissipated into the heat dissipation stage 70 by the thermally conductive member 68. Therefore, an increase in the temperature of the qubit chip 30 due to the heat transmitted through the interposer 20 may be suppressed.

After the interposer 20 is mounted over the printed circuit board 10, the cover portion 60, the heat dissipation fin 66, and the thermally conductive member 68 are removed as in FIGs. 4A and 4B.

In the second embodiment, as in FIGs. 6A and 6C, the cover portion 60 that covers the qubit chip 30 is disposed over the interposer 20. After the cover portion 60 is disposed, as in FIGs. 6B and 6D, the second bump 22 is locally heated to mount the interposer 20 over the printed circuit board 10. With the cover portion 60 for covering the qubit chip 30 provided, the heat when the second bump 22 is locally heated may be suppressed from being transferred through the air to reach the qubit chip 30. Accordingly, an increase in the temperature of the qubit chip 30 may be suppressed, and a change in the characteristics of the qubit chip 30 may be suppressed.

Furthermore, in the second embodiment, as in FIGs. 6A and 6C, the heat dissipation fin 66 (heat dissipation member) is disposed above the interposer 20. After the heat dissipation fin 66 is disposed, as in FIGs. 6B and 6D, the second bump 22 is locally heated to mount the interposer 20 over the printed circuit board 10. By the interposer 20 being provided with the heat dissipation fin 66, the heat when the second bump 22 is locally heated may be suppressed from being transferred through the interposer 20 to reach the qubit chip 30. Accordingly, an increase in the temperature of the qubit chip 30 may be suppressed, and a change in the characteristics of the qubit chip 30 may be suppressed. From the viewpoint of suppressing the increase in the temperature of the qubit chip 30, the heat dissipation fin 66 is preferably provided to the interposer 20 to be disposed and positioned between the second bump 22 and the qubit chip 30 in plan view.

Furthermore, in the second embodiment, as in FIGs. 6B and 6D, the thermally conductive member 68 (heat dissipation member) is disposed between the interposer 20 and the heat dissipation stage 70. After the thermally conductive member 68 is disposed, the second bump 22 is locally heated to mount the interposer 20 over the printed circuit board 10. With the thermally conductive member 68 provided between the interposer 20 and the heat dissipation stage 70, the heat when the second bump 22 is locally heated may be suppressed from being transferred through the interposer 20 to reach the qubit chip 30. Accordingly, an increase in the temperature of the qubit chip 30 may be suppressed, and a change in the characteristics of the qubit chip 30 may be suppressed. From the viewpoint of suppressing the increase in the temperature of the qubit chip 30, the thermally conductive member 68 is preferably provided to the interposer 20 to be disposed and positioned between the second bump 22 and the qubit chip 30 in plan view.

Furthermore, in the second embodiment, the second bump 22 is provided at the periphery of the interposer 20, and is not provided at the center of the interposer 20. That is, the second bump 22 is provided at a position not overlapping the qubit chip 30 in plan view, and no joining member for joining the printed circuit board 10 and the interposer 20 is provided at a position overlapping the qubit chip 30. Therefore, it becomes easy to locally heat the second bump 22, whereby an increase in the temperature of the qubit chip 30 may be suppressed.

Note that, while the exemplary case where all of the cover portion 60, the heat dissipation fin 66, and the thermally conductive member 68 are provided has been described in the second embodiment, at least one of the cover portion 60, the heat dissipation fin 66, or the thermally conductive member 68 may be provided.

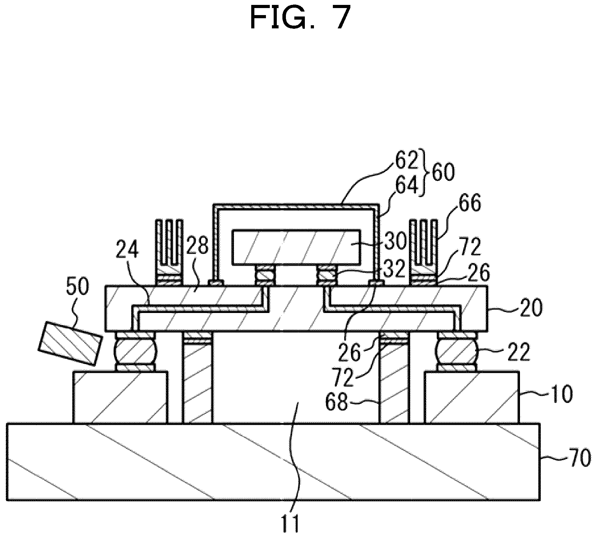

Note that, while the exemplary case where heat dissipation fin 66 and the thermally conductive member 68 are disposed in contact with the metal film 26 or the insulating film 28 of the interposer 20 has been described in the second embodiment, it is not limited to this case. FIG. 7 is a cross-sectional view illustrating another exemplary arrangement of the heat dissipation fin 66 and the thermally conductive member 68. As in FIG. 7, the heat dissipation fin 66 and the thermally conductive member 68 may be disposed on a thermally conductive resin film 72 (thermal interface material (TIM)) after the thermally conductive resin film 72 is applied to the interposer 20. For example, the thermally conductive resin film 72 may be a resin film to which a filler is added, such as boron nitride (BN), aluminum nitride (AlN), magnesium oxide (MgO), aluminum oxide (Al₂O₃), or the like. In this manner, by the heat dissipation fin 66 and the thermally conductive member 68 being provided to the interposer 20 to sandwich the thermally conductive resin film 72 with the interposer 20, the heat transmitted through the interposer 20 may be effectively dissipated. The thermally conductive resin film 72 is removed after the interposer 20 is mounted over the printed circuit board 10.

### [Third Embodiment]

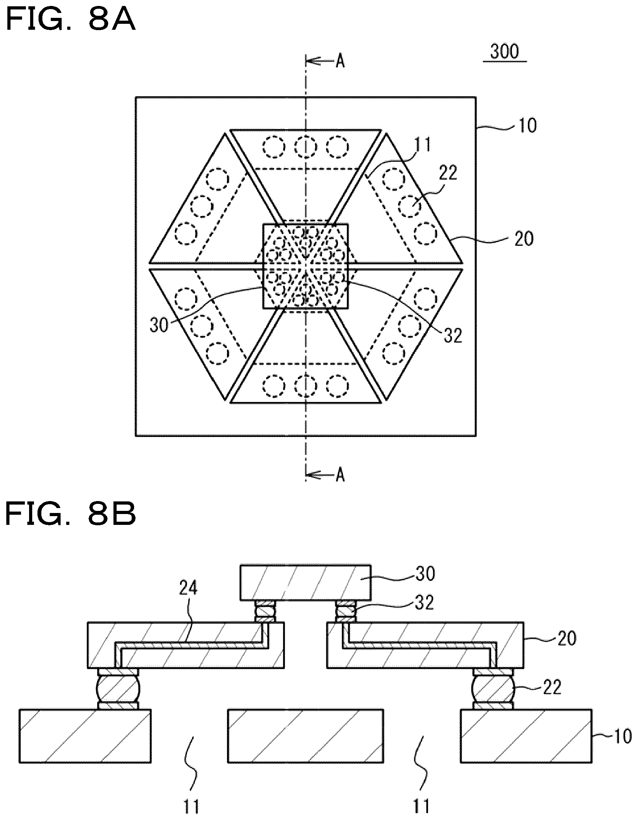

FIG. 8A is a plan view of a quantum device 300 according to a third embodiment, and FIG. 8B is a cross-sectional view taken along line A-A of FIG. 8A. As in FIGs. 8A and 8B, in the quantum device 300 according to the third embodiment, a qubit chip 30 is mounted across a plurality of interposers 20 by a first bump 32. Each of the plurality of interposers 20 has, for example, a triangular shape in plan view. The plurality of interposers 20 gathers with a space therebetween, thereby forming, for example, a substantially hexagonal shape in plan view. A second bump 22 is provided along a side corresponding to an outer periphery of each of the plurality of interposers 20, and the first bump 32 is provided near a vertex formed by the remaining two sides. Note that the plurality of interposers 20 may have another shape, such as a quadrangular shape. A printed circuit board 10 has a plurality of through holes 11 penetrating from the upper surface to the lower surface. The plurality of individual through holes 11 is provided at positions overlapping the plurality of individual interposers 20 in plan view and at positions not overlapping the first bump 32 and the second bump 22. The first bump 32 and the second bump 22 are positioned to sandwich the through hole 11 in plan view. Other configurations are the same as those in the first embodiment, and descriptions thereof will be omitted.

### [Manufacturing Method]

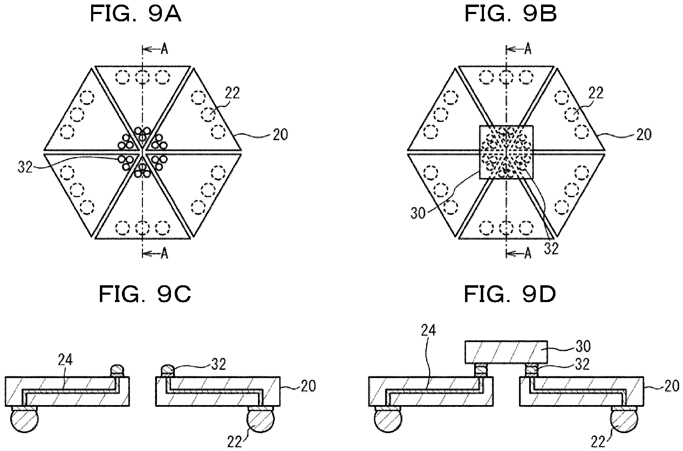

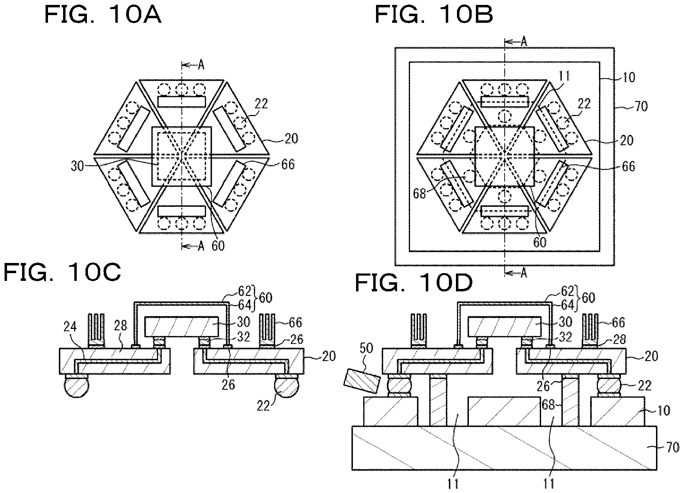

FIGs. 9A to 10D are diagrams illustrating a method according to the present invention for manufacturing the quantum device 300 according to the third embodiment. FIGs. 9A, 9B, 10A, and 10B are plan views illustrating the method for manufacturing the quantum device 300 according to the third embodiment. FIGs. 9C, 9D, 10C, and 10D are cross-sectional views taken along line A-A of FIGs. 9A, 9B, 10A, and 10B.

As in FIGs. 9A and 9C, the first bump 32 is formed over the upper surface of each of the plurality of interposers 20, and the second bump 22 is formed under the lower surface. The plurality of interposers 20 has, for example, a triangular shape in plan view. The second bump 22 is formed along one side of the triangle, and the first bump 32 is formed near the vertex formed by the remaining two sides.

As in FIGs. 9B and 9D, the qubit chip 30 is mounted across the plurality of interposers 20 by the first bump 32. The qubit chip 30 is mounted over the interposer 20 by the low-heat treatment described in the first embodiment. In a similar manner to the first embodiment, the second bump 22 is positioned in a region not overlapping the qubit chip 30 in plan view, and no joining member for joining the printed circuit board 10 and the interposer 20 is provided in a region overlapping the qubit chip 30.

As in FIGs. 10A and 10C, a cover portion 60 that covers the qubit chip 30 is disposed to spread over the upper surfaces of the plurality of interposers 20. In addition, a heat dissipation fin 66 is disposed above the upper surface of each of the plurality of interposers 20.

As in FIGs. 10B and 10D. the printed circuit board 10 and a thermally conductive member 68 are disposed above a heat dissipation stage 70. The thermally conductive member 68 is disposed in each of the plurality of through holes 11 formed in the printed circuit board 10 to be positioned below each of the plurality of interposers 20. The interposer 20 is disposed above the thermally conductive member 68. As a result, the thermally conductive member 68 is positioned between the lower surface of the interposer 20 and the heat dissipation stage 70. Next, the second bump 22 is locally heated using a heater 50 to mount the interposer 20 over the printed circuit board 10. After the interposer 20 is mounted over the printed circuit board 10, the cover portion 60, the heat dissipation fin 66, and the thermally conductive member 68 are removed as in FIGs. 8A and 8B.

In the third embodiment, as in FIGs. 9B and 9D, the qubit chip 30 is mounted across the plurality of interposers 20. As in FIGs. 10B and 10D, the plurality of interposers 20 provided with the qubit chip 30 is mounted over the printed circuit board 10. Since the interposer 20 is a substrate including a conductor layer and an insulating layer, warpage occurs due to a difference in linear expansion coefficient between the conductor layer and the insulating layer.

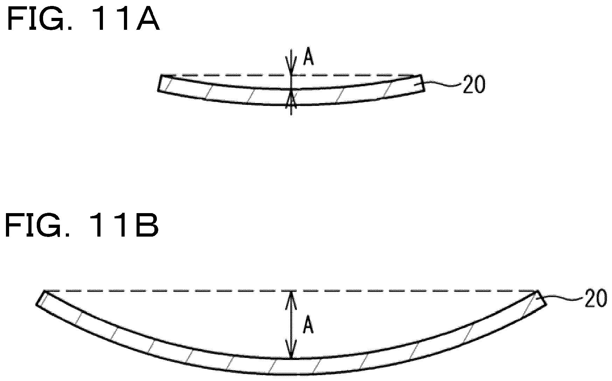

FIGs. 11A and 11B are cross-sectional views illustrating an outer shape and an amount of warpage of the interposer 20. As in FIGs. 11A and 11B, when warpage with the same curvature occurs in the interposers 20 having different outer shape sizes, an amount of warpage A of the interposer 20 having a smaller outer shape (FIG. 11A) is smaller than that of the interposer 20 having a larger outer shape (FIG. 11B). Therefore, as compared with the interposer 20 in the second embodiment illustrated in FIGs. 5B and 5D, the amount of warpage of each of the plurality of interposers 20 in the third embodiment is smaller.

As described above, by the qubit chip 30 being provided across the plurality of interposers 20, the outer shapes of the interposers 20 are made smaller, and the amount of warpage may be made smaller. Thus, the interposers 20 may be favorably mounted over the printed circuit board 10.

Furthermore, in the third embodiment, as in FIGs. 10B and 10D, the printed circuit board 10 has the through hole 11 that overlaps the interposer 20 and is positioned at least between the qubit chip 30 and the second bump 22 in plan view. Also in the second embodiment, as in FIGs. 6B and 6D, the printed circuit board 10 has the through hole 11 that overlaps the interposer 20 and is positioned at least between the qubit chip 30 and the second bump 22 in plan view. Sine the printed circuit board 10 is provided with a wiring layer, the heat when the second bump 22 is locally heated propagates through the printed circuit board 10. However, with the through hole 11 provided in the printed circuit board 10, the heat when the second bump 22 is locally heated may be suppressed from being transferred to the qubit chip 30 through the printed circuit board 10.

Note that, while the exemplary case where the plurality of through holes 11 is provided in the printed circuit board 10 has been described in the third embodiment, one through hole 11 in which the plurality of through holes 11 are coupled may be provided in a similar manner to the second embodiment. On the other hand, while the exemplary case where one through hole 11 is provided in the printed circuit board 10 has been described in the second embodiment, a plurality of the through holes 11 obtained by dividing one through hole 11 into multiple pieces may be provided in a similar manner to the third embodiment.

### [Fourth Embodiment]

A quantum device according to a fourth embodiment has the same structure as the quantum device 200 according to the second embodiment illustrated in FIGs. 4A and 4B, and thus descriptions thereof will be omitted.

### [Manufacturing Method]

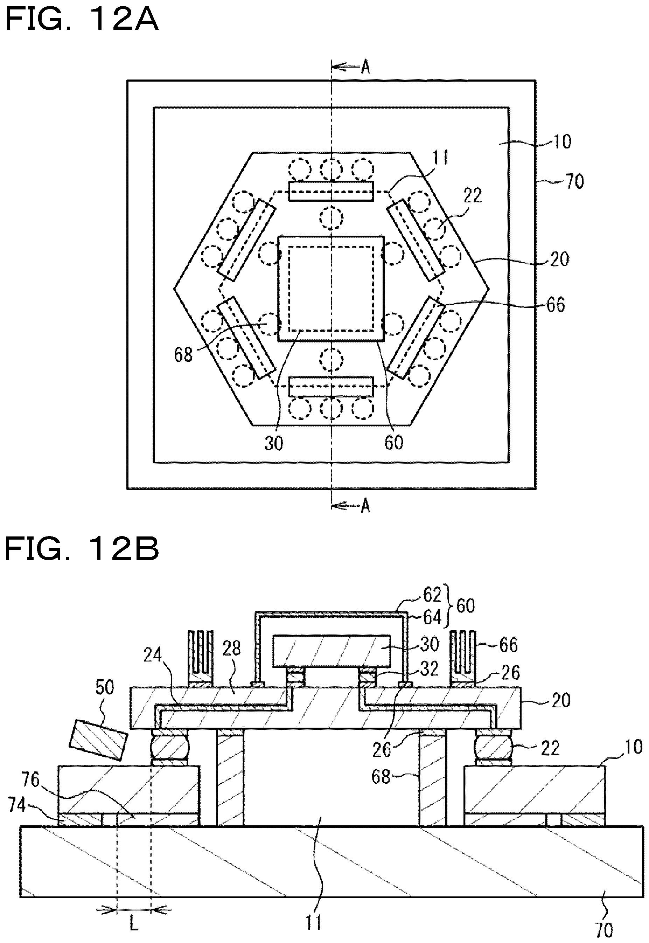

FIG. 12A is a plan view illustrating a method according to the present invention for manufacturing the quantum device according to the fourth embodiment, and FIG. 12B is a cross-sectional view taken along line A-A of FIG. 12A. First, the manufacturing process illustrated in FIGs. 5A to 5D, 6A, and 6C according to the second embodiment is performed.

Thereafter, as in FIGs. 12A and 12B, a printed circuit board 10 is disposed over a heat dissipation stage 70 via a metal portion 74 and a low thermal conducting portion 76. The metal portion 74 may be formed of, for example, a metal material such as copper, aluminum, or the like. The low thermal conducting portion 76 may be formed of, for example, rubber or resin such as silicone rubber, polyimide resin, or the like, or may be air. The low thermal conducting portion 76 is provided to overlap a second bump 22 in plan view. Thereafter, in a similar manner to the second embodiment, an interposer 20 is disposed over a thermally conductive member 68. As a result, the thermally conductive member 68 is positioned between the lower surface of the interposer 20 and the heat dissipation stage 70. Next, the second bump 22 is locally heated using a heater 50 to mount the interposer 20 over the printed circuit board 10. After the interposer 20 is mounted over the printed circuit board 10, in a similar manner to the second embodiment, a cover portion 60, a heat dissipation fin 66, and the thermally conductive member 68 are removed.

According to the fourth embodiment, as in FIGs. 12A and 12B, the printed circuit board 10 is disposed over the heat dissipation stage 70 such that the low thermal conducting portion 76 is sandwiched therebetween. Thereafter, the second bump 22 is locally heated to mount the interposer 20 over the printed circuit board 10. With the low thermal conducting portion 76 provided, the heat when the second bump 22 is locally heated is less likely to escape toward the heat dissipation stage 70 via the printed circuit board 10, whereby the temperature of the second bump 22 is easily increased locally. The low thermal conducting portion 76 may be formed of a member having a thermal conductivity lower than that of the member of the upper surface of the heat dissipation stage 70, such as rubber or resin.

Furthermore, in the fourth embodiment, as in FIG. 12B, the low thermal conducting portion 76 is provided to overlap the second bump 22 in plan view. Accordingly, the temperature of the second bump 22 is easily increased locally. A distance L between the second bump 22 and the end of the low thermal conducting portion 76 is, for example, approximately 1 cm to 3 cm. Furthermore, the metal portion 74 is provided between the printed circuit board 10 and the heat dissipation stage 70 at a position not overlapping the second bump 22 and outside the low thermal conducting portion 76 in plan view. As a result, unnecessary heat may be dissipated to the heat dissipation stage 70 while the temperature of the second bump 22 is locally increased, whereby an increase in the temperature of a qubit chip 30 may be suppressed.

### [Fifth Embodiment]

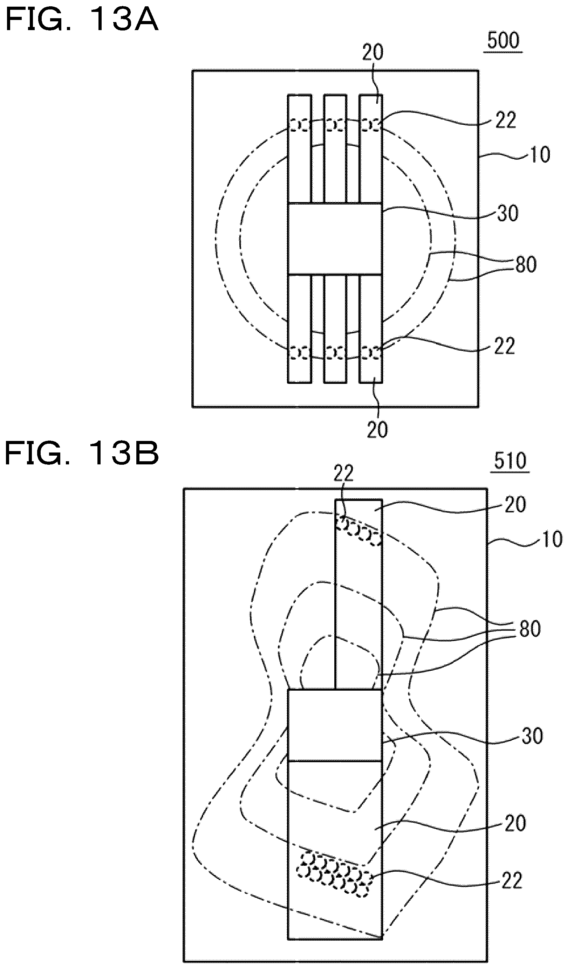

FIG. 13A is a plan view of a quantum device 500 according to a fifth embodiment, and FIG. 13B is a plan view of a quantum device 510 according to a variation of the fifth embodiment. In FIGs. 13A and 13B, contour lines 80 are illustrated by dash-dotted lines in which warpage occurs in a printed circuit board 10 and a height from a reference point (e.g., point on the lowermost side or uppermost side (lowest position or highest position) of the printed circuit board 10) is the same. As in FIGs. 13A and 13B, in the quantum devices 500 and 510 according to the fifth embodiment and the variation thereof, a plurality of second bumps 22 formed over one or a plurality of interposers 20 is formed near the same contour line 80 of the printed circuit board 10. As described above, the plurality of second bumps 22 is provided at positions at the same height from the reference point in the printed circuit board 10, whereby the interposer 20 may be favorably mounted over the printed circuit board 10 by the second bumps 22 even when the printed circuit board 10 is warped. The position at the same height from the reference point is not limited to the position at the completely same height, and includes a range in which the height is slightly deviated within a range in which joining of the second bumps 22 may be favorably carried out.

The warpage of the printed circuit board 10 varies depending on a difference in linear expansion coefficient between a conductor layer and an insulating layer, a shape of a conductor pattern in the conductor layer, and the like. Since the difference in linear expansion coefficient and the shape of the conductor pattern are determined by design, for example, the warpage that occurs in the printed circuit board 10 may be calculated by performing simulation using the finite element method, and the contour line 80 may be obtained. Alternatively, a prototype of the printed circuit board 10 may be prepared to measure the warpage that occurs in the printed circuit board 10 during the heating by measurement using a shadow moire, whereby the contour line 80 may be obtained.

### [Sixth Embodiment]

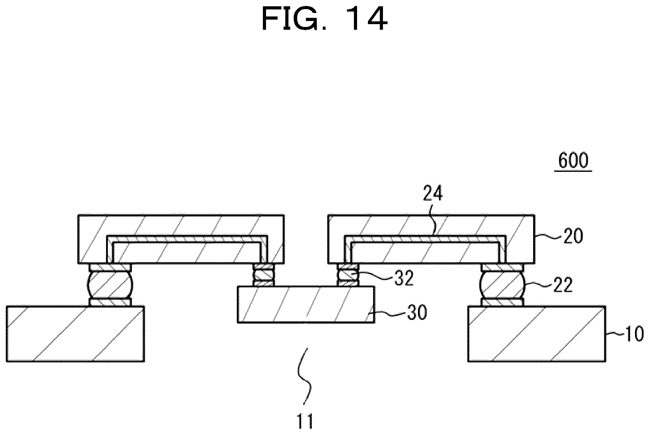

FIG. 14 is a cross-sectional view of a quantum device 600 according to a sixth embodiment. As in FIG. 14, in the quantum device 600 according to the sixth embodiment, a qubit chip 30 is mounted under a lower surface of an interposer 20 by a first bump 32. Other configurations are the same as those in the third embodiment, and descriptions thereof will be omitted.

### [Manufacturing Method]

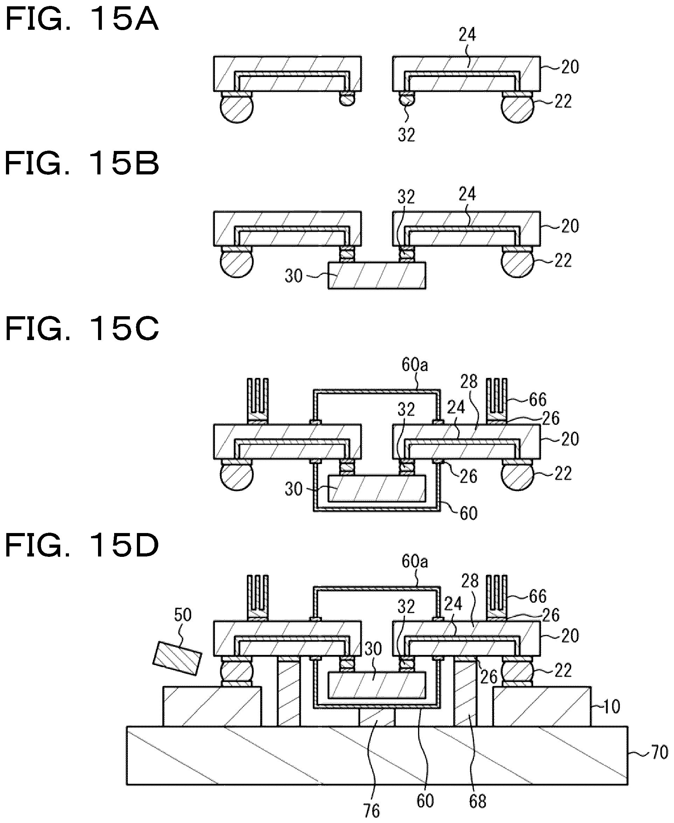

FIGs. 15A to 15D are cross-sectional views illustrating a method according to the present invention for manufacturing the quantum device 600 according to the sixth embodiment. As in FIG. 15A, the first bump 32 and a second bump 22 are formed under the lower surface of each of a plurality of the interposers 20.

As in FIG. 15B, the qubit chip 30 is mounted under the lower surfaces of the plurality of interposers 20 by the first bumps 32 to spread over the plurality of interposers 20. The qubit chip 30 is mounted over the interposer 20 by the low-heat treatment described in the first embodiment. In a similar manner to the first embodiment, the second bump 22 is positioned in a region not overlapping the qubit chip 30 in plan view, and no joining member for joining the printed circuit board 10 and the interposer 20 is provided in a region overlapping the qubit chip 30.

As in FIG. 15C, a heat dissipation fin 66 is disposed above the upper surface of the interposer 20. A cover portion 60 that covers the qubit chip 30 is disposed under the lower surface of the interposer 20. When the qubit chip 30 is mounted across the plurality of interposers 20, a cover portion 60a that is positioned above the qubit chip 30 and covers a gap between the plurality of interposers 20 may be disposed over the upper surfaces of the interposers 20.

As in FIG. 15D, the printed circuit board 10 and a thermally conductive member 68 are disposed above a heat dissipation stage 70. A low thermal conducting portion 76 may be disposed above the heat dissipation stage 70 to be positioned between the heat dissipation stage 70 and the cover portion 60. The interposer 20 is disposed above the thermally conductive member 68. As a result, the thermally conductive member 68 is positioned between the lower surface of the interposer 20 and the heat dissipation stage 70. Next, the second bump 22 is locally heated using a heater 50 to mount the interposer 20 over the printed circuit board 10. After the interposer 20 is mounted over the printed circuit board 10, the cover portions 60 and 60a, the heat dissipation fin 66, and the thermally conductive member 68 are removed as in FIG. 14.

While the exemplary case where the qubit chip 30 is mounted over the upper surface of the interposer 20 has been described in the first to fifth embodiments, the qubit chip 30 may be mounted under the lower surface of the interposer 20 as in the sixth embodiment.

While the exemplary case where the interposer 20 serves as a first substrate onto which the qubit chip 30 is mounted has been described in the first to sixth embodiments, another substrate may be used such as a package substrate. Furthermore, while the exemplary case where the printed circuit board 10 serves as a second substrate onto which the first substrate is mounted has been described, another substrate may be used such as a package substrate. Furthermore, one or more tiers of other substrates other than the first substrate and the second substrate may be mounted.

While the embodiments have been described in detail above, the embodiments are not limited to such specific embodiments, and various modifications and alternations may be made within the scope defined by the claims.

## Claims

1. A method for manufacturing a quantum device (100, 200, 300, 500, 600), the method comprising:
mounting a qubit chip (30) over a first substrate (20) by using a first bump (32); and
mounting the first substrate over a second substrate (10) by, after mounting the qubit chip, locally heating a second bump (22) provided at a position that does not overlap the qubit chip in plan view, wherein
no joining member that joins the first substrate and the second substrate is provided between the first substrate and the second substrate at a position that overlaps the qubit chip in plan view.

2. The method according to claim 1, further comprising:
disposing a cover portion (60)
that covers the qubit chip over the first substrate, wherein
the mounting the first substrate mounts the first substrate over the second substrate by locally heating the second bump after the cover portion is disposed.

3. The method according to claim 1 or 2, further comprising:
disposing a heat dissipation member over the first substrate, wherein
the mounting the first substrate mounts the first substrate over the second substrate by locally heating the second bump after the heat dissipation member is disposed.

4. The method according to claim 3, wherein the heat dissipation member includes a heat dissipation fin (66).

5. The method according to claim 3, wherein the heat dissipation member includes a thermally conductive member (68) disposed between the first substrate and a heat dissipation stage (70).

6. The method according to claim 3, wherein the heat dissipation member is disposed over the first substrate to be positioned between the second bump and the qubit chip in plan view.

7. The method according to claim 5, wherein the mounting the first substrate mounts the first substrate over the second substrate by locally heating the second bump after the second substrate is disposed over the heat dissipation stage such that a low thermal conducting portion (76) is sandwiched between the second substrate and the heat dissipation stage.

8. The method according to claim 3, wherein the heat dissipation member is disposed over the first substrate such that a thermally conductive resin film (72) is sandwiched between the heat dissipation member and the first substrate.

9. The method according to claim 1 or 2, wherein
the first bump includes an indium bump, a gold bump, or a copper bump, and
the second bump includes a solder bump.

10. The method according to claim 1 or 2, wherein
the mounting the qubit chip mounts the qubit chip across a plurality of the first substrates, and
the mounting the first substrate mounts the plurality of first substrates over the second substrate.

11. The method according to claim 1 or 2, wherein
a plurality of the second bumps is provided, and
the plurality of second bumps is provided to be positioned at a portion at a same height from a reference point in the second substrate in which warpage has occurred.

12. The method according to claim 1 or 2, wherein the qubit chip includes a Josephson junction device (45).

## Patentansprüche

1. Verfahren zur Herstellung einer Quantenvorrichtung (100, 200, 300, 500, 600), wobei das Verfahren umfasst:
Montieren eines Qubit-Chips (30) über einem ersten Substrat (20) unter Verwendung eines ersten Kontaktpunktes (32); und
Montieren des ersten Substrats über einem zweiten Substrat (10) nach Montieren des Qubit-Chips durch lokales Erwärmen eines zweiten Kontaktpunktes (22), der an einer Position bereitgestellt ist, die den Qubit-Chip in Draufsicht nicht überlappt, wobei
kein Verbindungselement, das das erste Substrat und das zweite Substrat verbindet, zwischen dem ersten Substrat und dem zweiten Substrat an einer Position bereitgestellt ist, die den Qubit-Chip in Draufsicht überlappt.

2. Verfahren nach Anspruch 1, weiter umfassend:
Anordnen eines Abdeckungsabschnitts (60), die den Qubit-Chip über das erste Substrat abdeckt, wobei
das Montieren des ersten Substrats das erste Substrat über das zweite Substrat durch lokales Erwärmen des zweiten Kontaktpunktes nach Anordnen des Abdeckungsabschnitts montiert.

3. Verfahren nach Anspruch 1 oder 2, weiter umfassend:
Anordnen eines Wärmeableitungselements über dem ersten Substrat, wobei
das Montieren des ersten Substrats das erste Substrat über das zweite Substrat durch lokales Erwärmen des zweiten Kontaktpunktes nach dem Anordnen des Wärmeableitungselements montiert.

4. Verfahren nach Anspruch 3, wobei das Wärmeableitungselement eine Wärmeableitungsrippe (66) einschließt.

5. Verfahren nach Anspruch 3, wobei das Wärmeableitungselement ein Wärmeleitungselement (68) einschließt, das zwischen dem ersten Substrat und einer Wärmeableitungsstufe (70) angeordnet ist.

6. Verfahren nach Anspruch 3, wobei das Wärmeableitungselement über dem ersten Substrat, das in Draufsicht zwischen dem zweiten Kontaktpunkt und dem Qubit-Chip zu positionieren ist, angeordnet ist.

7. Verfahren nach Anspruch 5, wobei das Montieren des ersten Substrats das erste Substrat über dem zweiten Substrat durch lokales Erwärmen des zweiten Kontaktpunktes montiert, nachdem das zweite Substrat über der Wärmeableitungsstufe so angeordnet ist, dass ein Niedrigwärmeleitungsabschnitt (76) zwischen dem zweiten Substrat und der Wärmeableitungsstufe eingeschoben ist.

8. Verfahren nach Anspruch 3, wobei das Wärmeableitungselement über dem ersten Substrat so angeordnet ist, dass eine Wärmeleitungsharzfolie (72) zwischen dem Wärmeableitungselement und dem ersten Substrat eingeschoben ist.

9. Verfahren nach Anspruch 1 oder 2, wobei
der erste Kontaktpunkt einen Indium-Kontaktpunkt, einen Gold-Kontaktpunkt oder einen Kupfer-Kontaktpunkt einschließt und
der zweite Kontaktpunkt einen Lötkontaktpunkt einschließt.

10. Verfahren nach Anspruch 1 oder 2, wobei
das Montieren des Qubit-Chips den Qubit-Chip über eine Vielzahl von ersten Substraten montiert, und
das Montieren des ersten Substrats die Vielzahl von ersten Substraten über dem zweiten Substrat montiert.

11. Verfahren nach Anspruch 1 oder 2, wobei
eine Vielzahl von zweiten Kontaktpunkten bereitgestellt ist, und
die Vielzahl von zweiten Kontaktpunkten bereitgestellt ist, um an einem Abschnitt auf gleicher Höhe von einem Referenzpunkt in dem zweiten Substrat positioniert zu sein, in dem eine Verformung aufgetreten ist.

12. Verfahren nach Anspruch 1 oder 2, wobei der Qubit-Chip eine Josephson-Übergangs-Vorrichtung (45) einschließt.

## Revendications

1. Procédé de fabrication d'un dispositif quantique (100, 200, 300, 500, 600),
le procédé comprenant :
le montage d'une puce (30) qubit sur un premier substrat (20) en utilisant une première bosse (32) ; et
le montage du premier substrat sur un deuxième substrat (10) par, après montage de la puce qubit, chauffage local d'une deuxième bosse (22) prévue au niveau d'une position qui ne se chevauche pas avec la puce qubit en vue en plan, dans lequel
aucun organe de jonction qui relie le premier substrat et le deuxième substrat n'est prévu entre le premier substrat et le deuxième substrat à une position qui chevauche la puce qubit en vue en plan.

2. Procédé selon la revendication 1, comprenant en outre :
la disposition d'une portion de couvercle (60)
qui recouvre la puce qubit sur le premier substrat, dans lequel
le montage du premier substrat monte le premier substrat sur le deuxième substrat en chauffant localement la deuxième bosse après que la portion de couvercle est disposée.

3. Procédé selon la revendication 1 ou la revendication 2, comprenant en outre :
la disposition d'un organe de dissipation de chaleur sur le premier substrat, dans lequel
le montage du premier substrat monte le premier substrat sur le deuxième substrat
en chauffant localement la deuxième bosse après que l'organe de dissipation de chaleur est disposé.

4. Procédé selon la revendication 3, dans lequel l'organe de dissipation de chaleur inclut une ailette de dissipation de chaleur (66).

5. Procédé selon la revendication 3, dans lequel l'organe de dissipation de chaleur inclut un organe (68) thermoconducteur disposé entre le premier substrat et une platine de dissipation de chaleur (70).

6. Procédé selon la revendication 3, dans lequel l'organe de dissipation de chaleur est disposé sur le premier substrat pour être positionné entre la deuxième bosse et la puce qubit en vue en plan.

7. Procédé selon la revendication 5, dans lequel le montage du premier substrat monte le premier substrat sur le deuxième substrat en chauffant localement la deuxième bosse après que le deuxième substrat est disposé sur la platine de dissipation de chaleur de sorte qu'une portion (76) de conductivité thermique inférieure soit prise en sandwich entre le deuxième substrat et la platine de dissipation de chaleur.

8. Procédé selon la revendication 3, dans lequel l'organe de dissipation de chaleur est disposé sur le premier substrat de sorte qu'un film de résine (72) thermoconducteur est pris en sandwich entre l'organe de dissipation de chaleur et le premier substrat.

9. Procédé selon la revendication 1 ou la revendication 2, dans lequel
la première bosse inclut une bosse d'indium, une bosse d'or ou une bosse de cuivre, et
la deuxième bosse inclut une bosse de brasure.

10. Procédé selon la revendication 1 ou la revendication 2, dans lequel
le montage de la puce qubit monte la puce qubit sur une pluralité des premiers substrats ; et
le montage du premier substrat monte la pluralité de premiers substrats sur le deuxième substrat.

11. Procédé selon la revendication 1 ou la revendication 2, dans lequel une pluralité de deuxièmes bosses est prévue, et
la pluralité de deuxièmes bosses est prévue pour être positionnée à une portion à la même hauteur par rapport à un point de référence dans le deuxième substrat dans lequel une déformation s'est produite.

12. Procédé selon la revendication 1 ou la revendication 2, dans lequel la puce qubit inclut un dispositif de jonction Josephson (45).
